# EUROPEAN PATENT SPECIFICATION

(11) **EP 1 578 756 B1**
(45) Date of publication and mention of the grant of the patent: **13.06.2007**
(21) Application number: 03782699.7
(22) Date of filing: 23.12.2003
(51) Int. Cl.: C07F 15/00, C09K 11/06, H05B 33/14, H01L 51/30

(54) **ELECTROLUMINESCENT MATERIALS AND DEVICES**
ELEKTROLUMINESZENTE VERBINDUNGEN UND VORRICHTUNGEN
SUBSTANCES ET DISPOSITIFS ELECTROLUMINESCENTS

(30) Priority: 24.12.2002 GB 0230076
(43) Date of publication of application: 28.09.2005
(73) Proprietor: OLED-T LIMITED, 8 Kinetic Crescent Innova Park Enfield EN3 7XH (GB)
(72) Inventor: KATHIRGAMANATHAN, Poopathy, North Harrow, HA2 7NN (GB); PRICE, Richard, London N8 0JB (GB); GANESHAMURUGAN, Subramaniam, London N15 4BB (GB); PARAMASWARA, Gnanamoly, London N10 8EB (GB)
(74) Representative: Lucas, Phillip Brian
(86) International application number: PCT/GB2003/005660
(87) International publication number: WO 2004/058783

(56) References cited:
- EP-A- 1 348 711
- WO-A-02/02714
- DATABASE WPI Section Ch, Week 200264 Derwent Publications Ltd., London, GB; Class E12, AN 2002-593370 XP002278089 -& JP 2002 105055 A (FUJI PHOTO FILM CO LTD) 10 April 2002 (2002-04-10)
- YAMAZAKI S: "Linkage modes of metal-tetraketone complexes" TRENDS IN INORGANIC CHEMISTRY, vol. 1, 1990, pages 75-84, XP0008030188
- CHARLES R G: "Metal Chelate Polymers Derived from Tetraacetylethane" JOURNAL OF POLYMER SCIENCE PART A, vol. 1, 1963, pages 267-276, XP002278088

## Description

The present invention relates to electroluminescent materials and to electroluminescent devices.

Materials which emit light when an electric current is passed through them are well known and used in a wide range of display applications. Liquid crystal devices and devices which are based on inorganic semiconductor systems are widely used; however these suffer from the disadvantages of high energy consumption, high cost of manufacture, low quantum efficiency and the inability to make flat panel displays.

Organic polymers have been proposed as useful in electroluminescent devices, but it is not possible to obtain pure colours; they are expensive to make and have a relatively low efficiency.

Another compound which has been proposed is aluminium quinolate, but this requires dopants to be used to obtain a range of colours and has a relatively low efficiency.

Patent application JP 2002105055A discloses iridium and diiridium complexes used in electroluminescent devices.

Patent application WO98/58037 describes a range of lanthanide complexes which can be used in electroluminescent devices which have improved properties and give better results. Patent Applications PCT/GB98/01773, PCT/GB99/03619, PCT/GB99/04030, PCT/GB99/04024, PCT/GB99/04028, PCT/GB00/00268 describe electroluminescent complexes, structures and devices using rare earth chelates.

US Patent 5128587 discloses an electroluminescent device which consists of an organometallic complex of rare earth elements of the lanthanide series sandwiched between a transparent electrode of high work function and a second electrode of low work function with a hole conducting layer interposed between the electroluminescent layer and the transparent high work function electrode and an electron conducting layer interposed between the electroluminescent layer and the electron injecting low work function anode. The hole conducting layer and the electron conducting layer are required to improve the working and the efficiency of the device. The hole transporting layer serves to transport holes and to block the electrons, thus preventing electrons from moving into the electrode without recombining with holes. The recombination of carriers therefore mainly takes place in the emitter layer.

We have now devised electroluminescent compounds and electroluminescent structures incorporating them.

According to the invention there is provided an electroluminescent diiridium compound of formula 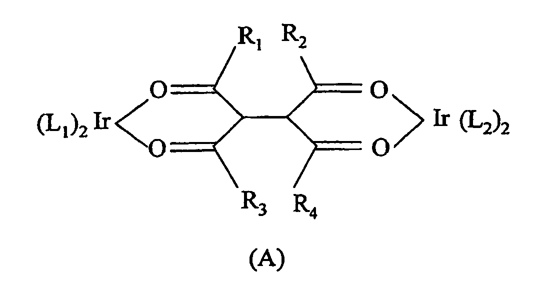 where R₁, R₂, R₃ and R₄ can be the same or different and are selected from hydrogen, and substituted and unsubstituted hydrocarbyl groups such as substituted and unsubstituted aliphatic groups, substituted and unsubstituted aromatic, heterocyclic and polycyclic ring structures, fluorocarbons such as trifluoryl methyl groups, halogens such as fluorine or thiophenyl groups; R₁, R₂ and R₃ can also form substituted and unsubstituted fused aromatic, heterocyclic and polycyclic ring structures and can be copolymerisable with a monomer, e.g. styrene.

Examples of R₁ and/or R₂ and/or R₃ and/or R₄ include aliphatic, aromatic and heterocyclic alkoxy, aryloxy and carboxy groups, substituted and unsubstituted phenyl, fluorophenyl, biphenyl, phenanthrene, anthracene, naphthyl and fluorene groups, alkyl groups such as t-butyl, heterocyclic groups such as carbazole.

Preferred organic ligands L₁ and L₂ are phenylpyridine and substituted phenylpryidines.

The invention also provides an electroluminescent device which comprises (i) a first electrode, (ii) a layer of the diiridium complex (A) and (iii) a second electrode.

The first electrode can function as the cathode and the second electrode can function as the anode and preferably there is a layer of a hole transporting material between the anode and the layer of the electroluminescent compound.

The hole transporting material can be any of the hole transporting materials used in electroluminescent devices.

The hole transporting material can be an amine complex such as poly (vinylcarbazole), N, N'-diphenyl-N, N'-bis (3-methylphenyl) -1,1' -biphenyl -4,4'-diamine (TPD), an unsubstituted or substituted polymer of an amino substituted aromatic compound, a polyaniline, substituted polyanilines, polythiophenes, substituted polythiophenes, polysilanes etc. Examples of polyanilines are polymers of 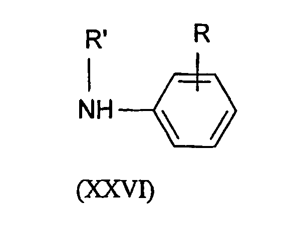 where R is in the ortho - or meta-position and is hydrogen, C1-18 alkyl, C1-6 alkoxy, amino, chloro, bromo, hydroxy or the group 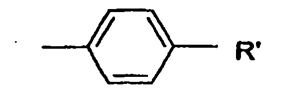 where R is alky or aryl and R' is hydrogen, C1-6 alkyl or aryl with at least one other monomer of the formula immediately above, or the hole transporting material can be a polyaniline; polyanilines which can be used in the present invention have the general formula 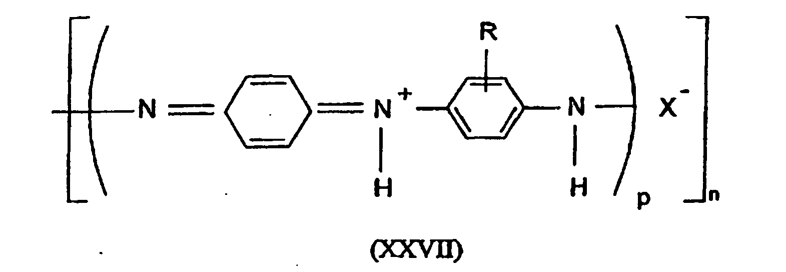 where p is from 1 to 14 and n is from 1 to 20, R is as defined above and X is an anion, preferably selected from Cl, Br, SO₄, BF₄, PF₆, H₂PO₃, H₂PO₄, arylsulphonate, arenedicarboxylate, polystyrenesulphonate, polyacrylate alkysulphonate, vinylsulphonate, vinylbenzene sulphonate, cellulose sulphonate, camphor sulphonates, cellulose sulphate or a perfluorinated polyanion.

Examples of arylsulphonates are p-toluenesulphonate, benzenesulphonate, 9,10-anthraqumone-sutphonate and anthracenesulphonate; an example of an arenedicarboxylate is phthalate and an example of arenecarboxylate is benzoate.

We have found that protonated polymers of the unsubstituted or substituted polymer of an amino substituted aromatic compound such as a polyaniline are difficult to evaporate or cannot be evaporated. However we have surprisingly found that if the unsubstituted or substituted polymer of an amino substituted aromatic compound is deprotonated then it can be easily evaporated, i.e. the polymer is evaporable.

Preferably evaporable deprotonated polymers of unsubstituted or substituted polymers of an amino substituted aromatic compound are used. The de-protonated unsubstituted or substituted polymer of an amino substituted aromatic compound can be formed by deprotonating the polymer by treatment with an alkali such as ammonium hydroxide or an alkali metal hydroxide such as sodium hydroxide or potassium hydroxide.

The degree of protonation can be controlled by forming a protonated polyaniline and de-protonating. Methods of preparing polyanilines are described in the article by A. G. MacDiarmid and A. F. Epstein, Faraday Discussions, Chem Soc.88 P319 1989.

The conductivity of the polyaniline is dependent on the degree of protonation with the maximum conductivity being when the degree of protonation is between 40 and 60%, e.g. about 50%.

Preferably the polymer is substantially fully deprotonated.

A polyaniline can be formed of octamer units, i.e. p is four, e.g.

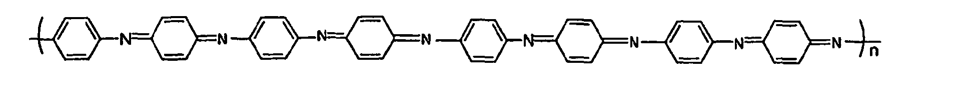

The polyanilines can have conductivities of the order of 1 x 10⁻¹ Siemen cm⁻¹ or higher.

The aromatic rings can be unsubstituted or substituted, e.g. by a Cl to 20 alkyl group such as ethyl.

The polyaniline can be a copolymer of aniline and preferred copolymers are the copolymers of aniline with o-anisidine, m-sulphanilic acid or o-aminophenol, or o-toluidine with o-aminophenol, o-ethylaniline, o-phenylene diamine or with amino anthracenes.

Other polymers of an amino substituted aromatic compound which can be used include substituted or unsubstituted polyaminonapthalenes, polyaminoanthracenes, polyaminophenanthrenes, etc. and polymers of any other condensed polyaromatic compound. Polyaminoanthracenes and methods of making them are disclosed in US Patent 6,153,726. The aromatic rings can be unsubstituted or substituted, e.g. by a group R as defined above.

Other hole transporting materials are conjugated polymers and the conjugated polymers which can be used can be any of the conjugated polymers disclosed or referred to in US 5807627, PCT/WO90/13148 and PCT/WO92/03490.

The preferred conjugated polymers are poly (p-phenylenevinylene)-PPV and copolymers including PPV. Other preferred polymers are poly(2,5 dialkoxyphenylene vinylene) such as poly (2-methoxy-5-(2-methoxypentyloxy-1,4-phenylene vinylene), poly(2-methoxypentyloxy)-1,4-phenylenevinylene), poly(2-methoxy-5-(2-dodecyloxy-1,4-phenylenevinylene) and other poly(2,5 dialkoxyphenylenevinylenes) with at least one of the alkoxy groups being a long chain solubilising alkoxy group, poly fluorenes and oligofluorenes, polyphenylenes and oligophenylenes, polyanthracenes and oligo anthracenes, ploythiophenes and oligothiophenes.

In PPV the phenylene ring may optionally carry one or more substituents, e.g. each independently selected from alkyl, preferably methyl, alkoxy, preferably methoxy or ethoxy.

Any poly(arylenevinylene) including substituted derivatives thereof can be used and the phenylene ring in poly(p-phenylenevinylene) may be replaced by a fused ring system such as anthracene or naphthlyene ring and the number of vinylene groups in each polyphenylenevinylene moiety can be increased, e.g. up to 7 or higher.

The conjugated polymers can be made by the methods disclosed in US 5807627, PCT/WO90/13148 and PCT/WO92/03490.

The thickness of the hole transporting layer is preferably 20nm to 200nm.

The polymers of an amino substituted aromatic compound such as polyanilines referred to above can also be used as buffer layers with or in conjunction with other hole transporting materials.

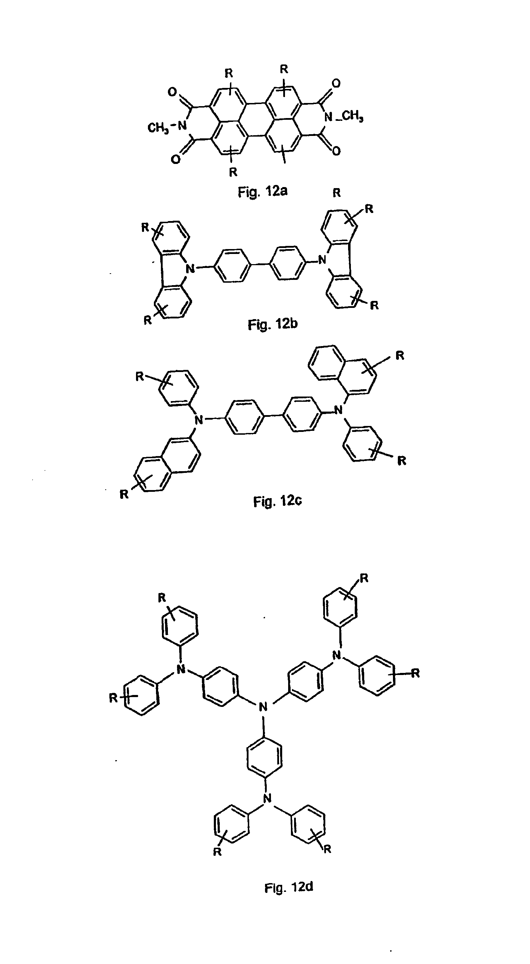

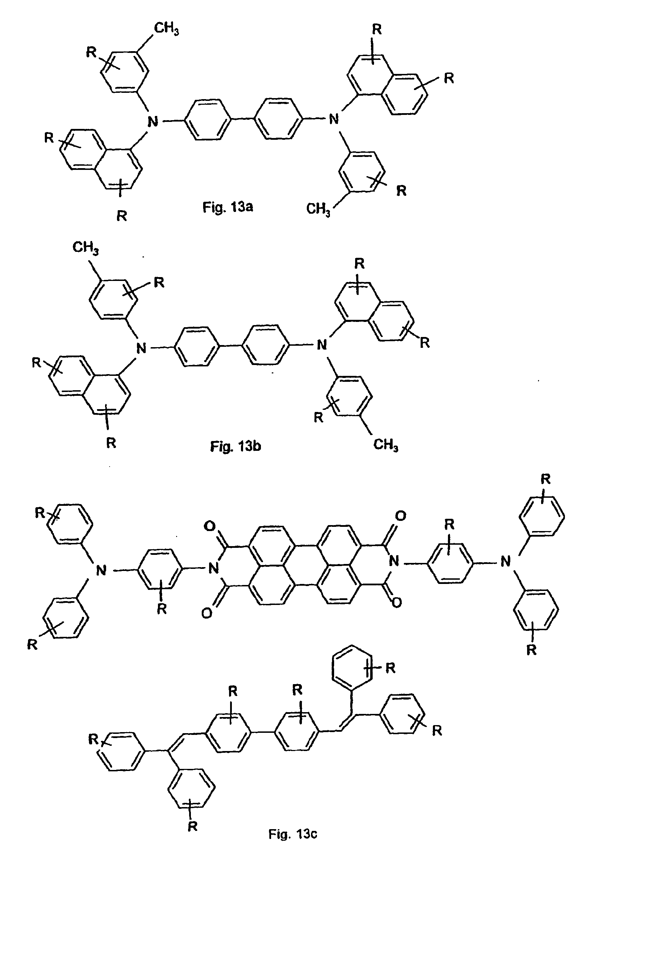

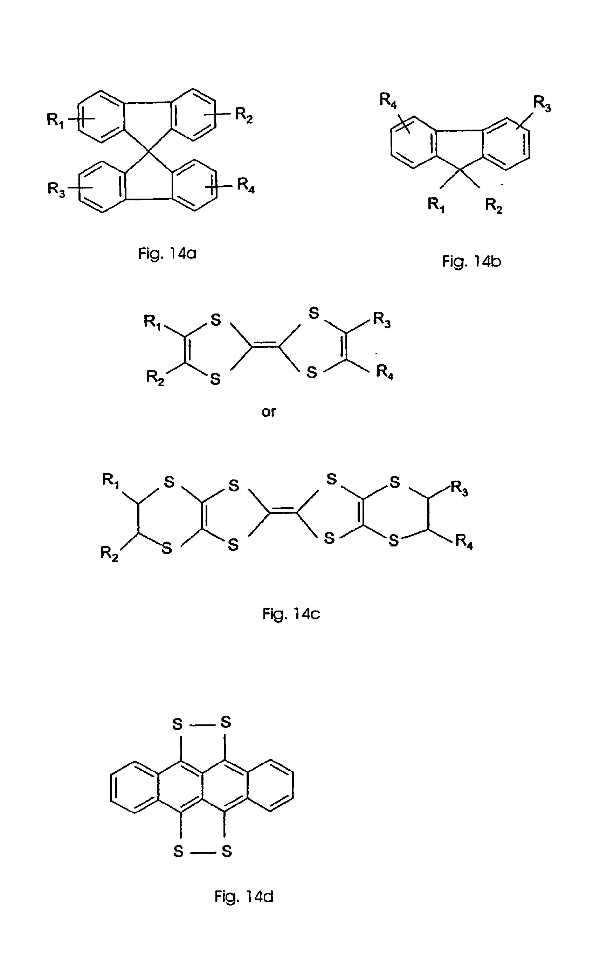

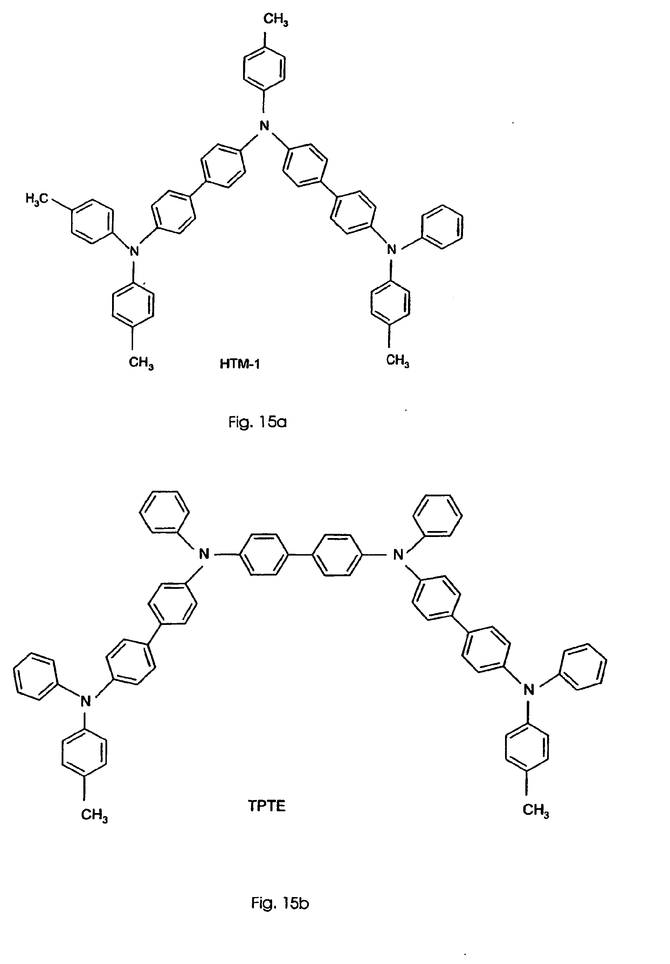

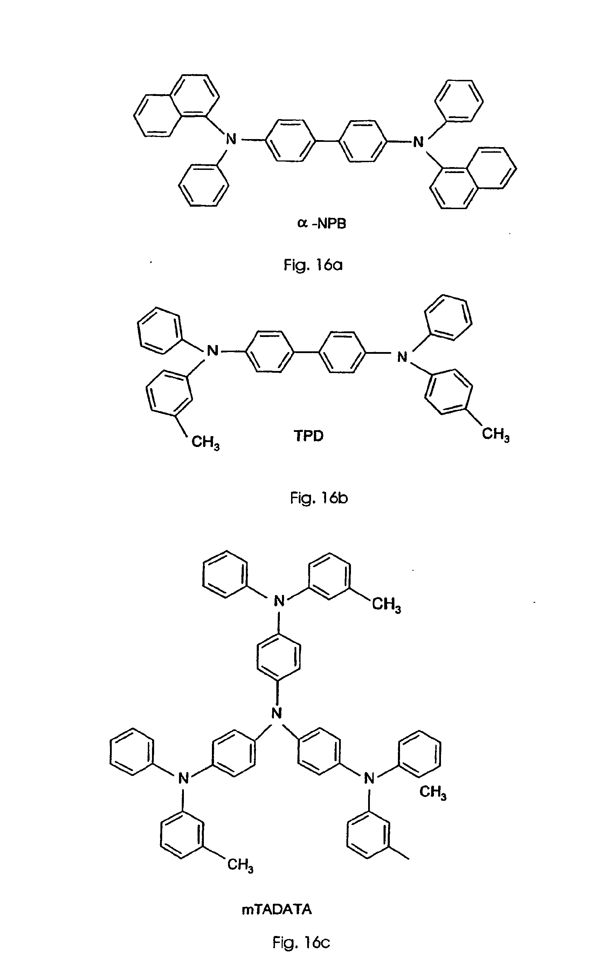

The structural formulae of some other hole transporting materials are shown in Figures 12 to 16 of the drawings, where R₁, R₂ and R₃ can be the same or different and are selected from hydrogen, and substituted and unsubstituted hydrocarbyl groups such as substituted and unsubstituted aliphatic groups, substituted and unsubstituted aromatic, heterocyclic and polycyclic ring structures, fluorocarbons such as trifluoryl methyl groups, halogens such as fluorine or thiophenyl groups; R₁, R₂ and R₃ can also form substituted and unsubstituted fused aromatic, heterocyclic and polycyclic ring structures and can be copolymerisable with a monomer, e.g. styrene. X is Se, S or O, Y can be hydrogen, substituted or unsubstituted hydrocarbyl groups, such as substituted and unsubstituted aromatic, heterocyclic and polycyclic ring structures, fluorine, fluorocarbons such as trifluoryl methyl groups, halogens such as fluorine or thiophenyl groups or nitrile.

Examples of R₁ and/or R₂ and/or R₃ include aliphatic, aromatic and heterocyclic alkoxy, aryloxy and carboxy groups, substituted and unsubstituted phenyl, fluorophenyl, biphenyl, phenanthrene, anthracene, naphthyl and fluorene groups alkyl groups such as t-butyl, heterocyclic groups such as carbazole.

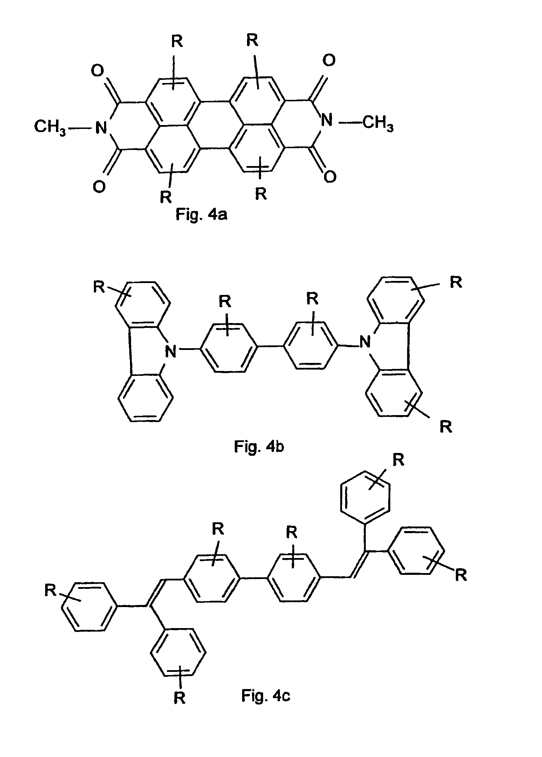

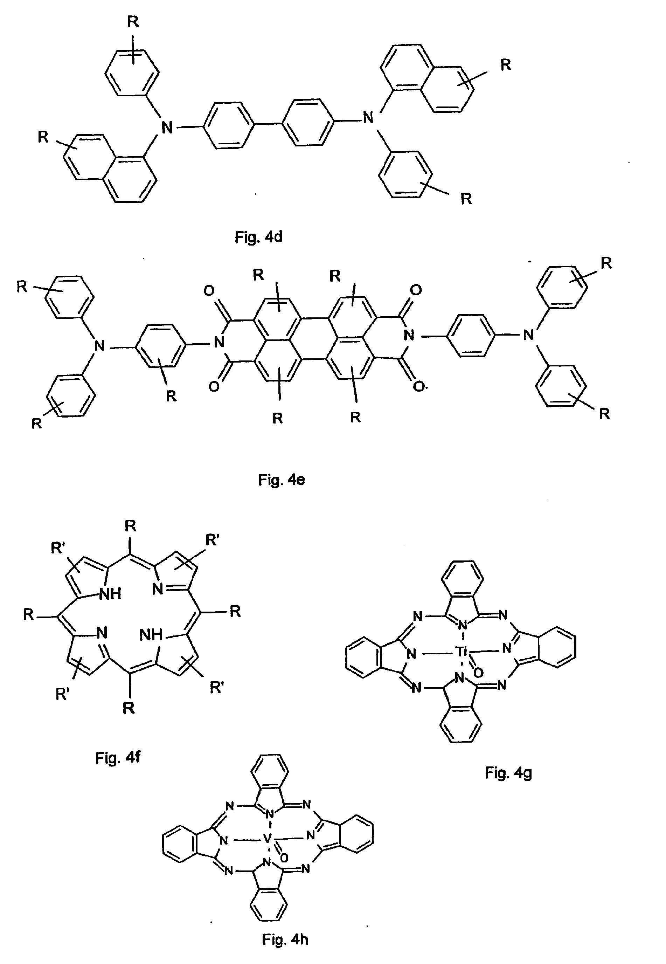

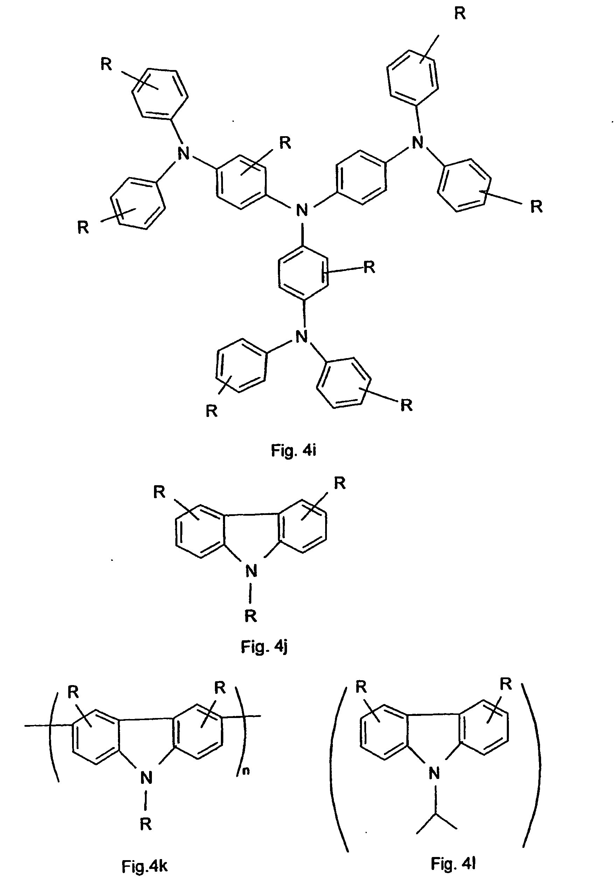

In an embodiment of the invention the hole transporting material is mixed with the electroluminescent compound in the electroluminescent layer and a preferred electroluminescent compound is CBP which has the formula of fig. 4b in the drawings.

There can be a buffer layer between the anode and the hole transporting layer and any of the hole transporting materials listed above can be used.

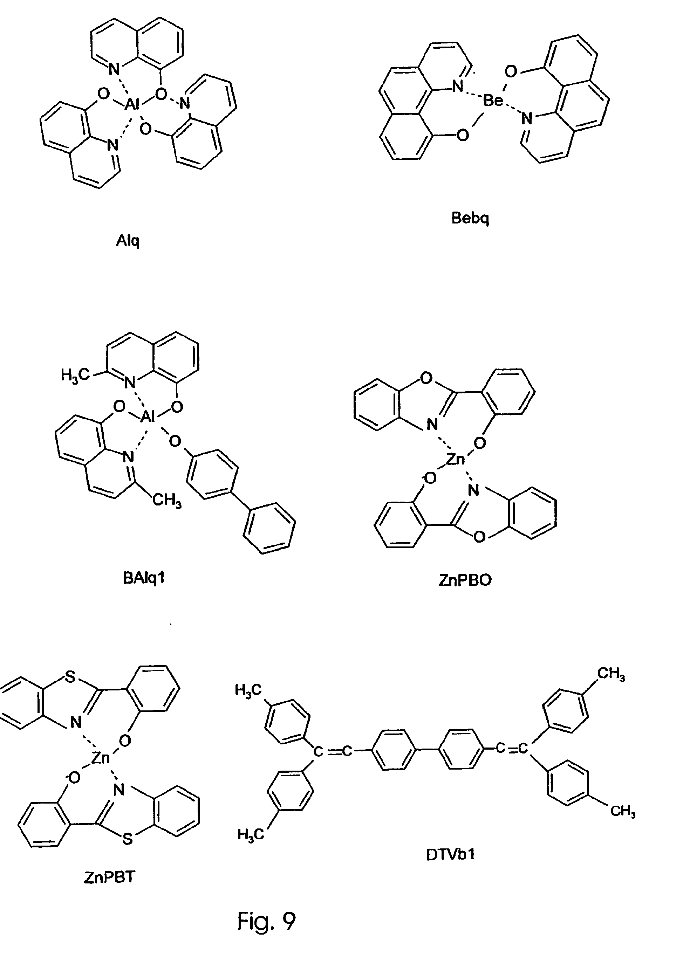

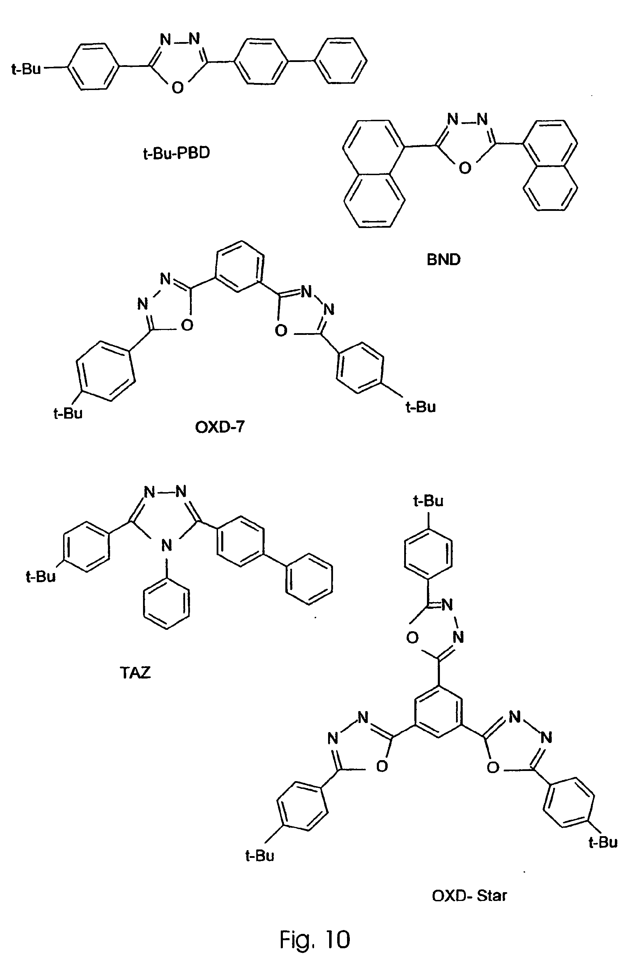

Optionally there is a layer of an electron injecting material between the cathode and the electroluminescent material layer. The electron injecting material is a material which will transport electrons; when an electric current is passed through electron injecting materials include a metal complex such as a metal quinolate, e.g. an aluminium quinolate, lithium quinolate, Mx(OBM)ₙ where Mx is a metal and DBM is dibenzoyl methane and n is the valency of Mx, e.g Mx is chromium. The electron injecting material can also be a cyano anthracene such as 9,10 dicyano anthracene, cyano substituted aromatic compounds, tetracyanoquinidodimethane a polystyrene sulphonate or a compound with the structural formulae shown in figures 9 or 10 of the drawings in which the phenyl rings can be substituted with substituents R as defined above. Instead of being a separate layer the electron injecting material can be mixed with the electroluminescent material and co-deposited with it.

Optionally the hole transporting material can be mixed with the electroluminescent material and co-deposited with it.

The hole transporting materials, the electroluminescent material and the electron injecting materials can be mixed together to form one layer, which simplifies the construction.

The anode is preferably a transparent substrate such as a conductive glass or plastic material which acts as the anode. Preferred substrates are conductive glasses such as indium tin oxide coated glass, but any glass which is conductive or has a conductive layer such as a metal or conductive polymer can be used. Conductive polymers and conductive polymer coated glass or plastics materials can also be used as the substrate.

The cathode is preferably a low work function metal, e.g. aluminium, calcium, lithium, magnesium and alloys thereof such as silver/magnesium alloys, rare earth metal alloys, etc; aluminium is a preferred metal. A metal fluoride such as an alkali metal, rare earth metal or their alloys can be used as the second electrode, for example by having a metal fluoride layer formed on a metal.

The diiridium compound (A) can be mixed with other electroluminescent compounds, for example europium complexes and the invention also provides an electroluminescent device which comprises (i) a first electrode, (ii) a layer of an electroluminescent europium organo metallic or organic complex mixed with an iridium organo metallic or organic complex and (iii) a second electrode.

There is preferably also a layer of an electroluminescent europium organo metallic or organic complex and the invention also provides electroluminescent devices of structures:- (i) a first electrode, (ii) a layer of an electroluminescent europium organo metallic or organic complex, (iii) a layer of an electroluminescent europium organo metallic or organic complex mixed with diiridium compound and (iv) a second electrode.

The electroluminescent europium organo metallic or organic complex preferably has the formula (Lα)₃Eu where Lα is an organic complex.

Preferred electroluminescent compounds which can be used in the present invention are of formula

(Lα)₃ Eu← Lp

where Lα and Lp are organic ligands and Lp is a neutral ligand. The ligands Lα can be the same or different and there can be a plurality of ligands Lp which can be the same or different.

For example (L₁)(L₂)(L₃)Eu (Lp) where (L₁)(L₂)(L₃) are the same or different organic complexes and (Lp) is a neutral ligand and the different groups (L₁)(L₂)(L₃) may be the same or different.

Lp can be monodentate, bidentate or polydentate and there can be one or more ligands Lp.

Further electroluminescent compounds which can be used in the present invention are of general formula (Lα)ₙEuM₂ where M₂ is a non rare earth metal, Lα is a as above and n is the combined valence state of Eu and M₂. The complex can also comprise one or more neutral ligands Lp so the complex has the general formula (Lα)ₙ Eu M₂ (Lp), where Lp is as above. The metal M₂ can be any metal which is not a rare earth, transition metal, lanthanide or an actinide. Examples of metals which can be used include lithium, sodium, potassium, rubidium, caesium, beryllium, magnesium, calcium, strontium, barium, copper (I), copper (II), silver, gold, zinc, cadmium, boron, aluminium, gallium, indium, germanium, tin (II), tin (IV), antimony (II), antimony (IV), lead (II), lead (IV) and metals of the first, second and third groups of transition metals in different valence states, e.g. manganese, iron, ruthenium, osmium, cobalt, nickel, palladium(II), palladium(IV), platinum(II), platinum(IV), cadmium, chromium, titanium, vanadium, zirconium, tantulum, molybdenum, rhodium, iridium, titanium, niobium, scandium, yttrium.

Preferably Lα is selected from β diketones such as those of formulae 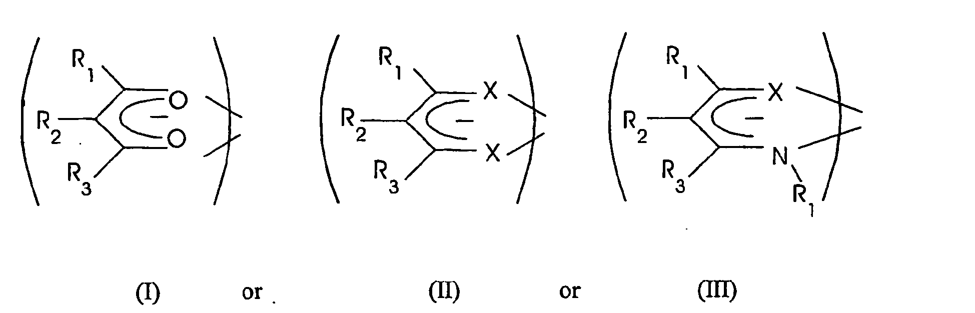 where R₁, R₂ and R₃ can be the same or different and are selected from hydrogen, and substituted and unsubstituted hydrocarbyl groups such as substituted and unsubstituted aliphatic groups, substituted and unsubstituted aromatic, heterocyclic and polycyclic ring structures, fluorocarbons such as trifluoryl methyl groups, halogens such as fluorine or thiophenyl groups. R₁, R₂ and R₃ can also form substituted and unsubstituted fused aromatic, heterocyclic and polycyclic ring structures and can be copolymerisable with a monomer, e.g. styrene. X is Se, S or O, Y can be hydrogen, substituted or unsubstituted hydrocarbyl groups, such as substituted and unsubstituted aromatic, heterocyclic and polycyclic ring structures, fluorine, fluorocarbons such as trifluoryl methyl groups, halogens such as fluorine or thiophenyl groups or nitrile.

Examples of R₁ and/or R₂ and/or R₃ include aliphatic, aromatic and heterocyclic alkoxy, aryloxy and carboxy groups, substituted and substituted phenyl, fluorophenyl, biphenyl, phenanthrene, anthracene, naphthyl and fluorene groups alkyl groups such as t-butyl, heterocyclic groups such as carbazole.

Some of the different groups Lα may also be the same or different charged groups such as carboxylate groups so that the group L₁ can be as defined above and the groups L₂, L₃... can be charged groups such as 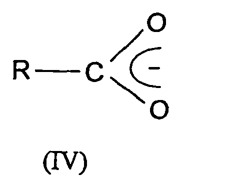 where R is R₁ as defined above or the groups L₁, L₂ can be as defined above and L₃ ... etc. are other charged groups.
R₁, R₂ and R₃ can also be 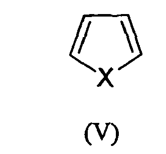 where X is O S, Se or NH.

A preferred moiety R₁ is trifluoromethyl CF₃ and examples of such diketones are, banzoyltrifluoroacetone, p-chlorobenzoyltrifluoroacetone, p-bromotrifluoroacetone, p-phenyltrifluoroacetone, 1-naphthoyltrifluoroacetone, 2-naphthoyltrifluoroacetone, 2-phenathoyltrifluoroacetone, 3-phenanthoyltrifluoroacetone, 9-anthroyltrifluoroacetonetrifluoroacetone, cinnamoyltrifluoroacetone, and 2-thenoyltrifluoroacetone.

The different groups Lα may be the same or different ligands of formulae 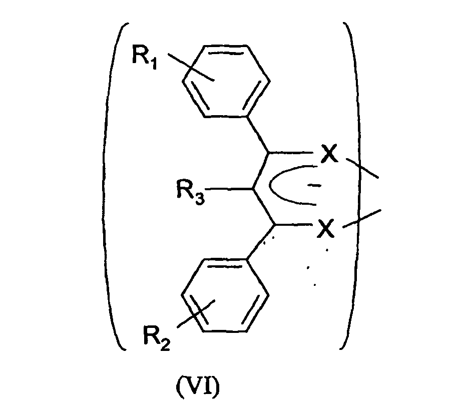 where X is O, S, or Se and R₁ R₂ and R₃ are as above.

The different groups Lα may be the same or different quinolate derivatives such as 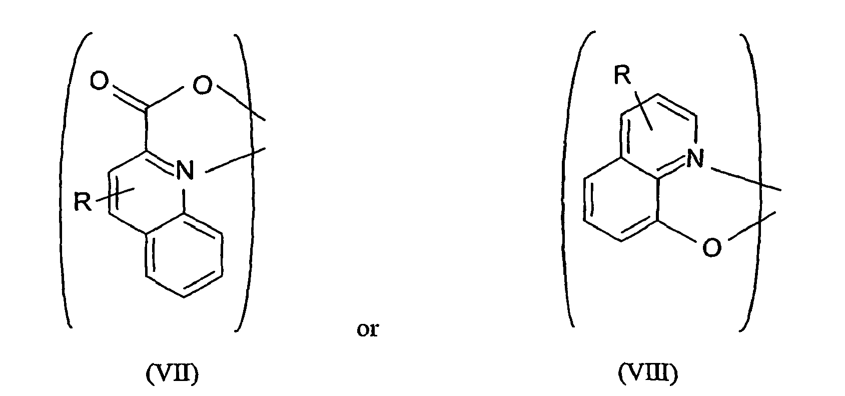 where R is hydrocarbyl, aliphatic, aromatic or heterocyclic carboxy, aryloxy, hydroxy or alkoxy, e.g. the 8 hydroxy quinolate derivatives or 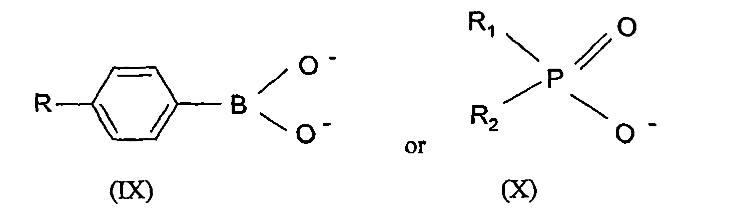 where R, R₁, and R₂ are as above or are H or F e.g. R₁ and R₂ are alkyl or alkoxy groups

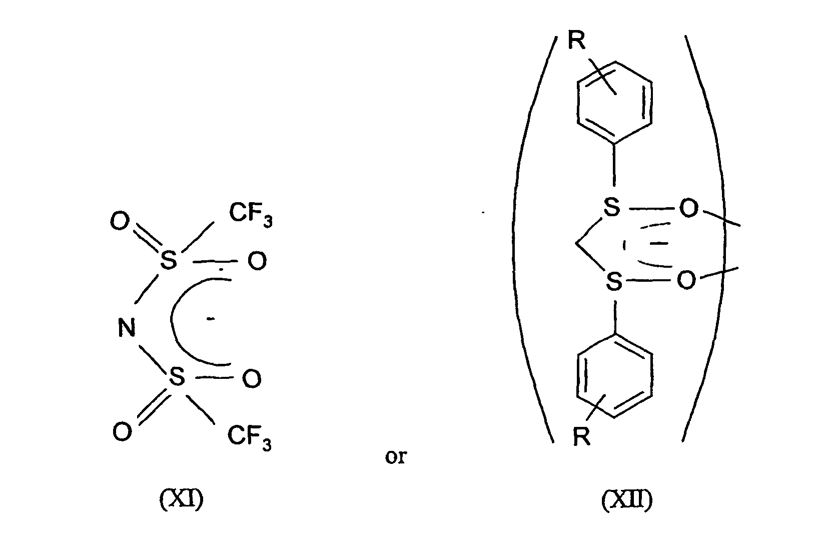

As stated above, the different groups Lα may also be the same or different carboxylate groups, e.g. 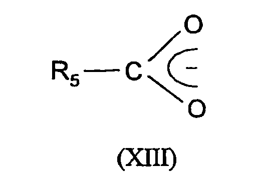 where R₅ is a substituted or unsubstituted aromatic, polycyclic or heterocyclic ring a polypyridyl group, R₅ can also be a 2-ethyl hexyl group so Lₙ is 2-ethylhexanoate or R₅ can be a chair structure so that Lₙ is 2-acetyl cyclohexanoate or Lα can be 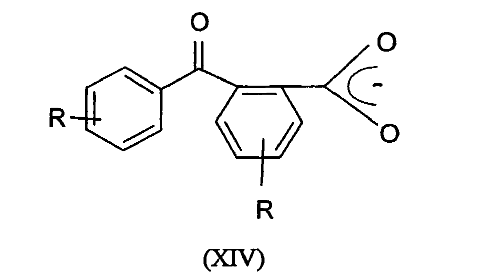 where R is as above, e.g. alkyl, allenyl, amino or a fused ring such as a cyclic or polycyclic ring.

The different groups Lα may also be 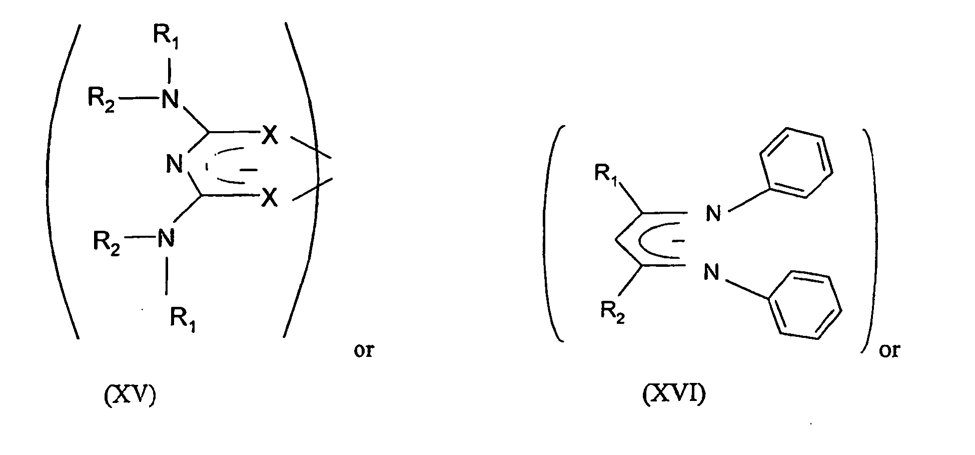 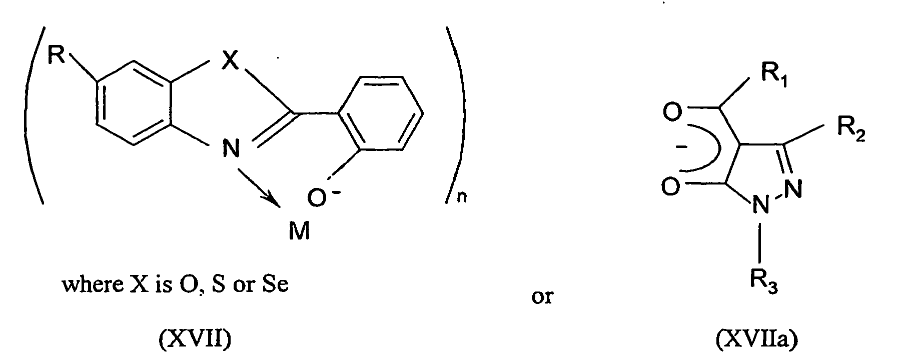 where R, R₁ and R₂ are as above or

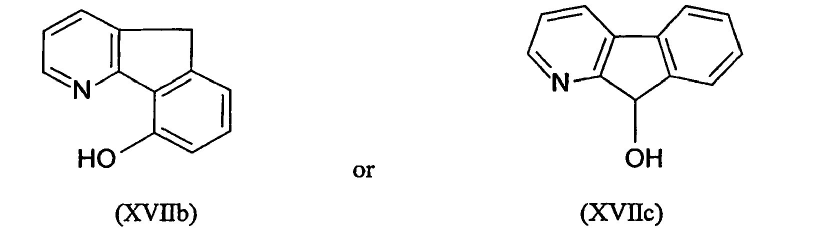

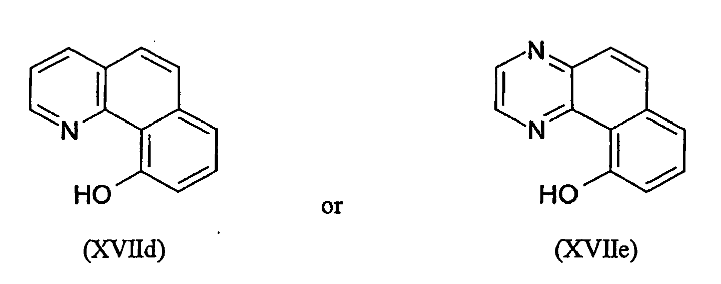

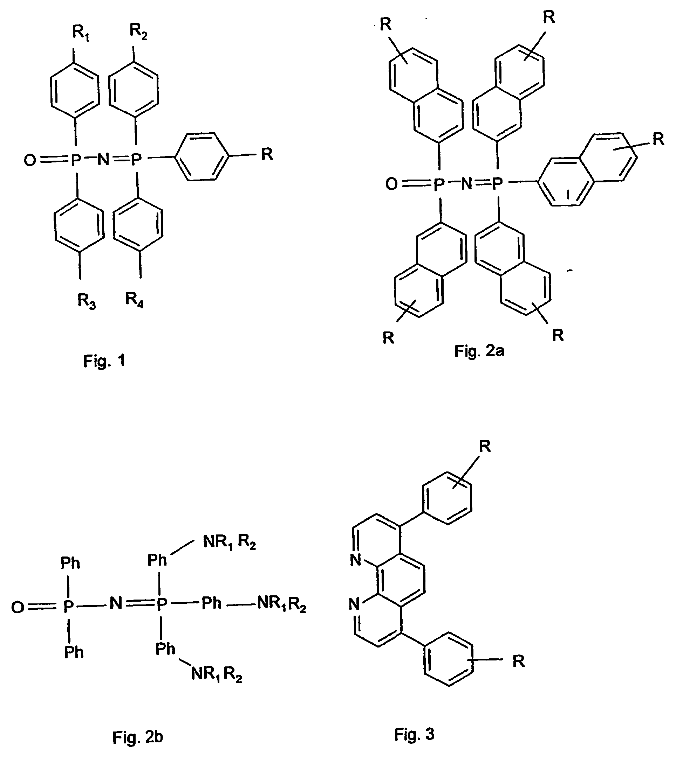

The groups Lp in the formula (A) above can be selected from 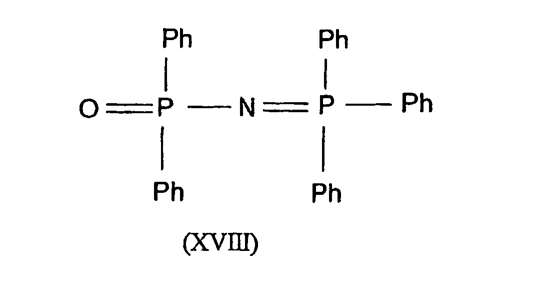 where each Ph which can be the same or different and can be a phenyl (OPNP) or a substituted phenyl group, other substituted or unsubstituted aromatic group, a substituted or unsubstituted heterocyclic or polycyclic group, a substituted or unsubstituted fused aromatic group such as a naphthyl, anthracene, phenanthrene or pyrene group. The substituents can be, for example, an alkyl, aralkyl, alkoxy, aromatic, heterocyclic, polycyclic group, halogen such as fluorine, cyano, amino, substituted amino etc. Examples are given in figs. 1 and 2 of the drawings where R, R₁, R₂, R₃ and R₄ can be the same or different and are selected from hydrogen, hydrocarbyl groups, substituted and unsubstituted aromatic, heterocyclic and polycyclic ring structures, fluorocarbons such as trifluoryl methyl groups, halogens such as fluorine or thiophenyl groups; R, R₁, R₂, R₃ and R₄ can also form substituted and unsubstituted fused aromatic, heterocyclic and polycyclic ring structures and can be copolymerisable with a monomer, e.g. styrene. R, R₁, R₂, R₃ and R₄ can also be unsaturated alkylene groups such as vinyl groups or groups

-C-CH₂=CH₂-R

where R is as above.

Lₚ can also be compounds of formulae 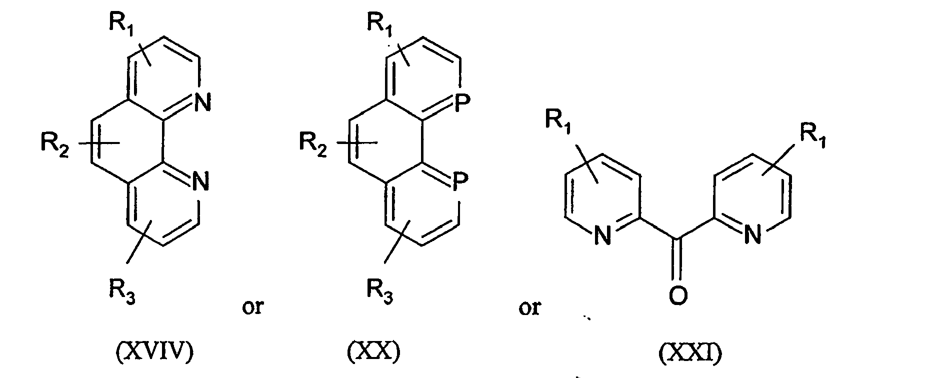 where R₁, R₂ and R₃ are as referred to above; for example bathophen shown in fig. 3 of the drawings in which R is as above or 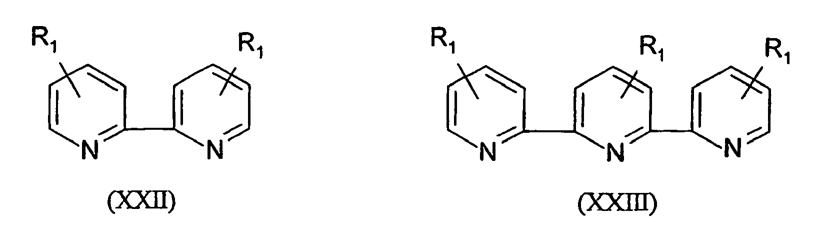 where R₁, R₂ and R₃ are as referred to above.

Lₚ can also be 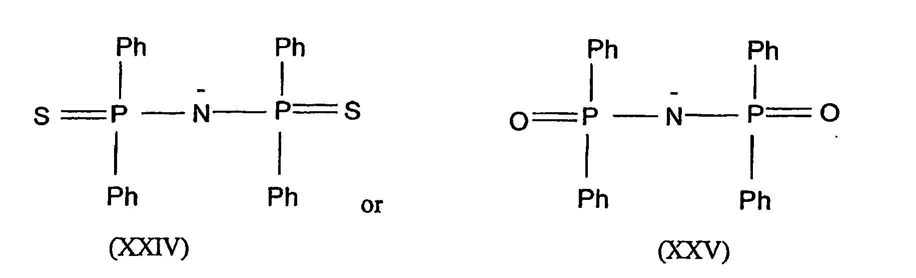 where Ph is as above.

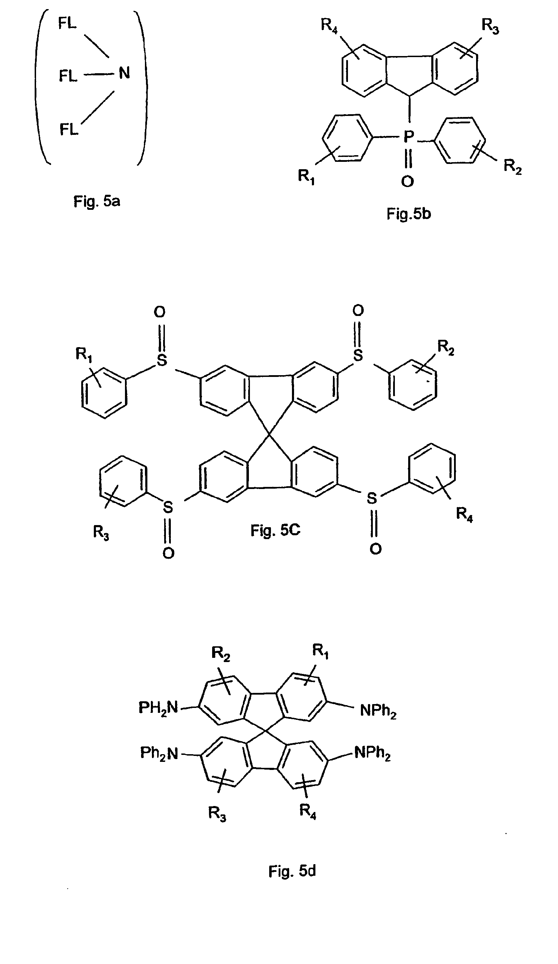

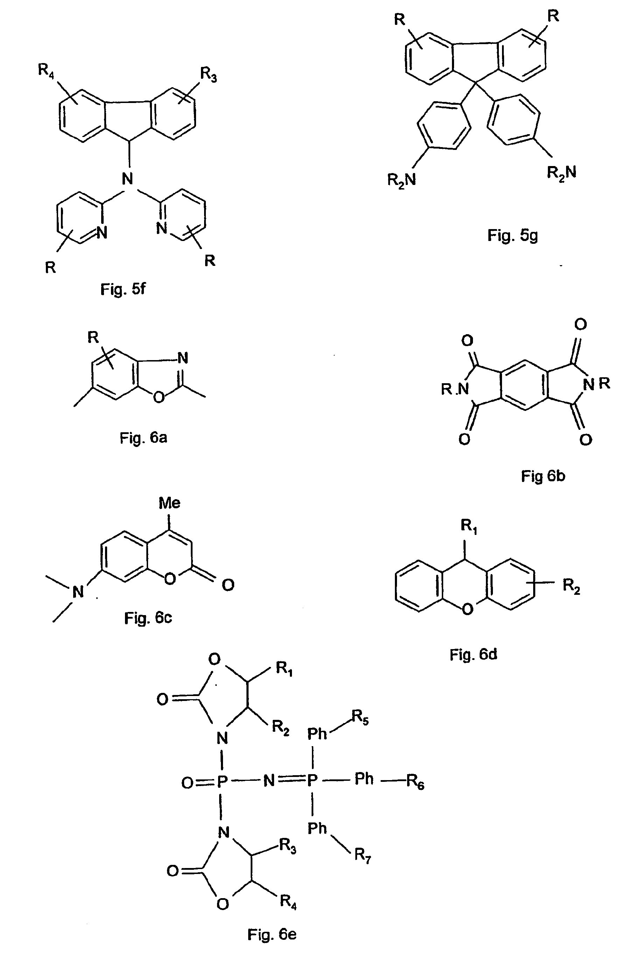

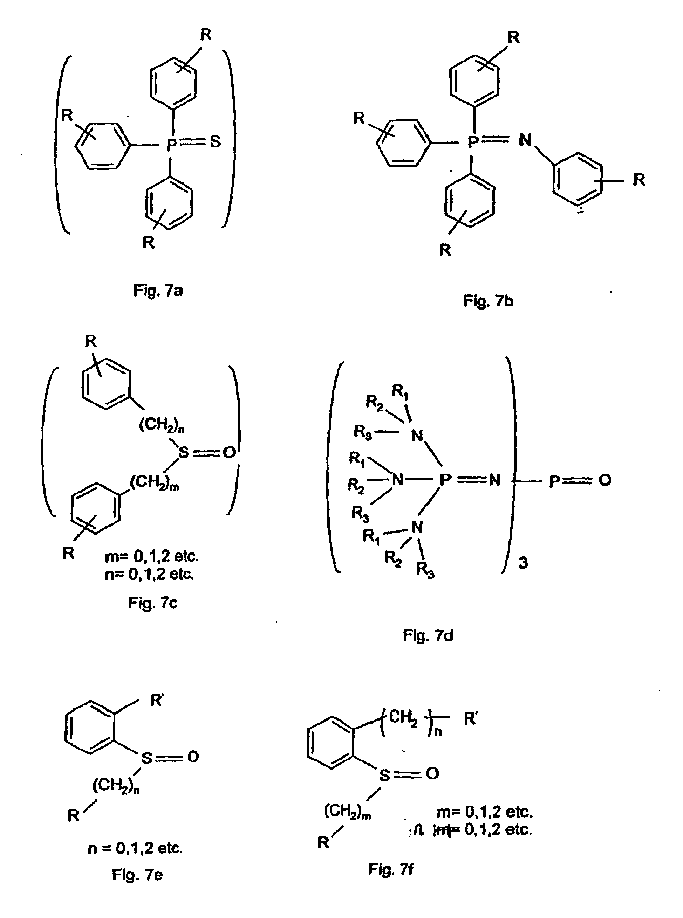

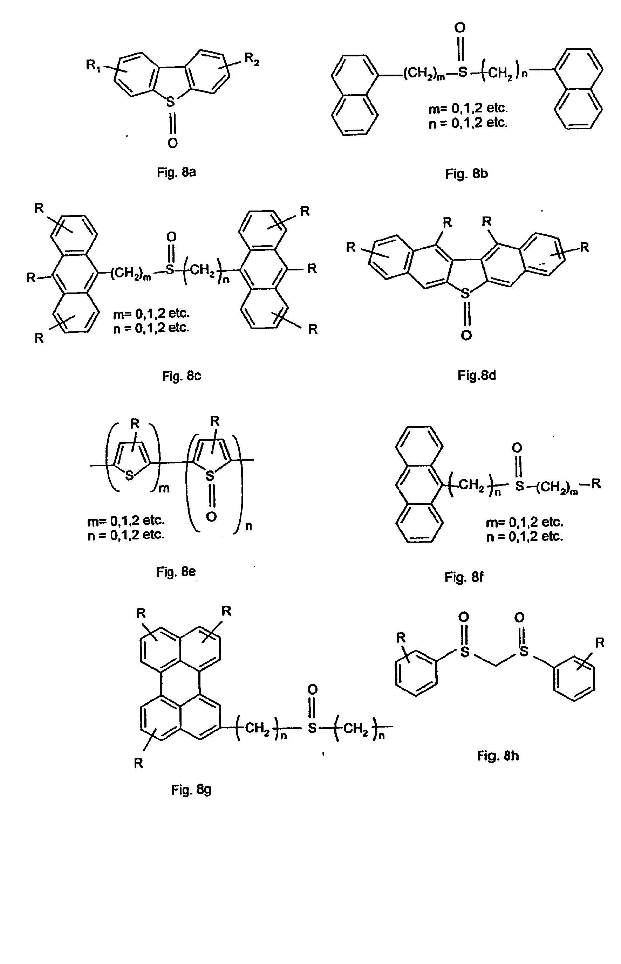

Other examples of Lₚ chelates are as shown in figs. 4 and fluorene and fluorene derivatives, e.g. as shown in fig. 5 and compounds of formulae as shown in figs. 6 to 8.

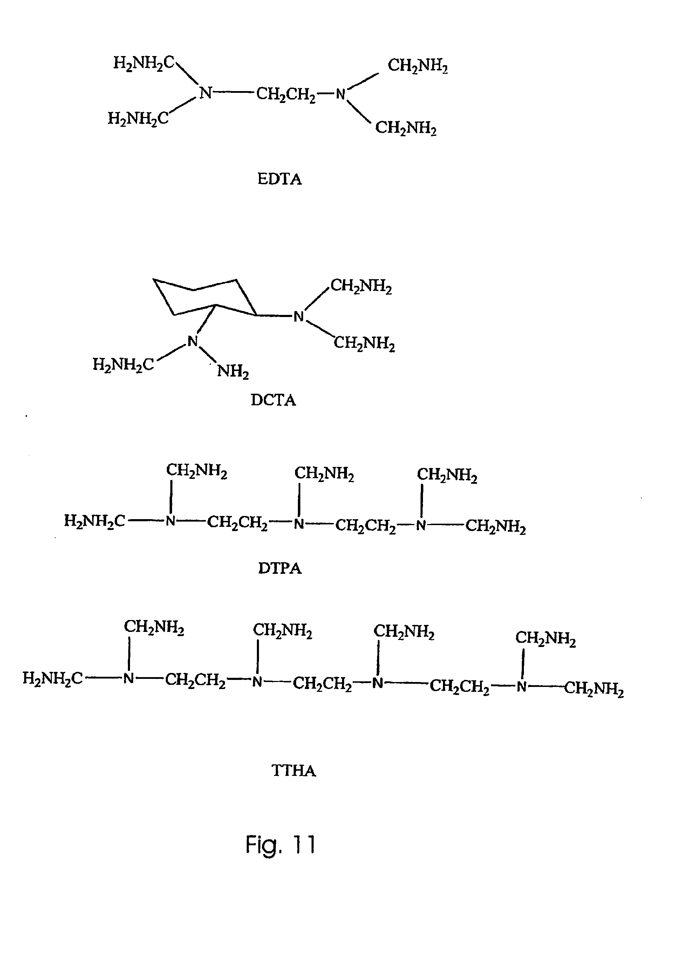

Specific examples of Lα and Lp are tripyridyl and TMHD, and TMHD complexes, α, α', α" tripyridyl, crown ethers, cyclans, cryptans phthalocyanans, porphoryins ethylene diamine tetramine (EDTA), DCTA, DTPA and TTHA. Where TMHD is 2,2,6,6-tetramethyl-3,5-heptanedionato and OPNP is diphenylphosphonimide triphenyl phosphorane. The formulae of the polyamines are shown in fig. 11.

A preferred europium complex is Eu(DBM)₃OPNP.

In one embodiment of the invention there is provided a structure which comprises (i) a first electrode, (ii) a layer of a hole transporting, (iii) a layer of an electroluminescent europium organo metallic or organic complex mixed with an iridium organo metallic or organic complex (A), (iv) an electron transmitting layer and (v) a second electrode and preferably there is also one or more layers of a europium electroluminescent organo metallic or organic complex adjacent to the layer (iii).

Optionally there can be other layers such as buffer layers in order that the holes and electrons combine in the electroluminescent layer and to improve the overall performance of the device.

The invention is illustrated in the examples which exemplify the synthesis of the diiridium complex and a device incorporating it.

### Example 1 - 3,4-diacetyl-2,5-hexanedione (I)

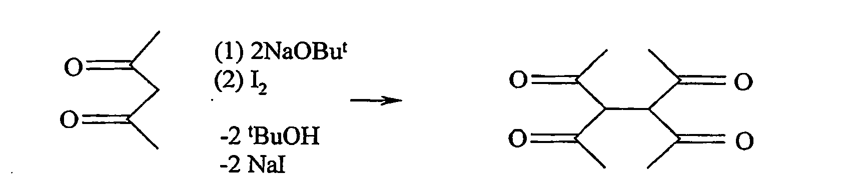

A three-necked 1 litre round-bottomed flask under an inert atmosphere (nitrogen) was charged with sodium tert-butoxide (30.0g, 310mmol) and a magnetic stirrer-bar. Thf (dried and distilled over Na/benzophenone, 500mL) was introduced, the temperature reduced to -78°C and pentane-2,4-dione (30.0g, 300mmol) in Thf (dried and distilled over Nalbenzophenone, 100mL) added over 30 min. The reaction was allowed to warm to around 0°C and cooled with an ice-bath to maintain the temperature below 5°C. Iodine (38.0g, 150mmol) in Thf (dried and distilled over Na/benzophenone, 100mL) was added dropwise. The reaction mixture was stirred for a further 30 min. with the ice-bath and then for 1 hour once the ice-bath had been removed. Diethylether (300mL) was added to the reaction mixture, which was then poured into 200mL saturated ammonium chloride solution (the pH was measured to ensure that the product had been neutralised). The organic layer was washed with 0.25M sodium thiosulfate solution (2 x 200mL) and then brine (200mL). The volatiles were removed *in vacuo* and the product recrystallised from ethanol (95%) to yield colourless crystals (19.3g, 65%). M.p. 193-4°C. The product was used without further purification.

### Example 2 -Tetrakis(2-phenylpyridine-C², N')(µ-chloro) diiridium (II)

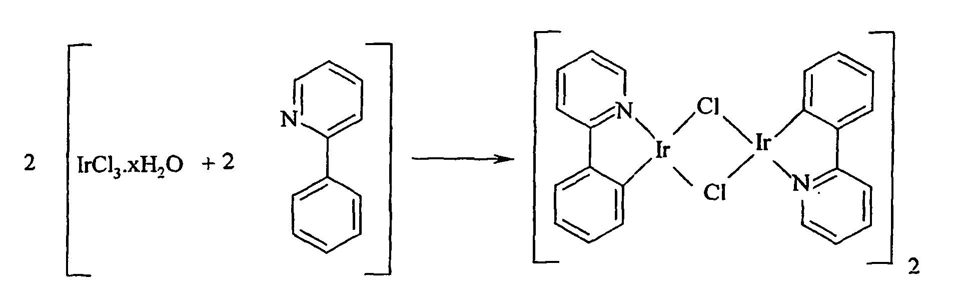

Iridium trichloride hydrate (0.388g) was combined with 2-phenylpyridine (0.76g), dissolved in a mixture of 2-ethoxyethanol (30mL, dried and distilled over MgSO₄) and water (10mL), and refluxed for 24 hours. The solution was cooled to room temperature and the yellow/green precipitate collected on a glass sinter. The precipitate was washed with ethanol (60mL, 95%), acetone (60mL), and then dissolved in dichloromethane (75mL) and filtered. Toluene (25mL) and hexane (10mL) were added to the filtrate and the volume reduced *in vacuo* to about 50mL. Cooling yielded crystals (yellow/green) of the desired product (0.43g, 72%). This was used without further purification.

### Example 3 - Tetrakis(2-phenylpiridine-C², N')(µ-3,4-diacetyl-2,5-hexanedionate) diiridium

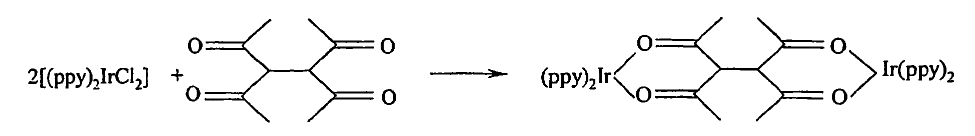

Tetrakis(2-phenylpyridine-C²,N')(µ-chloro) diiridium (II) (0.5g, 0.47mmol), 3,4-diacetyl-2,5- hexanedione (I) (0.092g, 0.47mmol) and sodium carbonate (dried at 100°C, 200mg, 1.9mmol) were refluxed under an inert atmosphere (nitrogen) in 2-ethoxyethanol (dried and distilled over magnesium sulfate, 50mL) for 12 hours. On cooling to room temperature, a yellow precipitate was collected on a sinter (porosity 3) and washed with water (50mL), hexane (50mL) and diethylether (50mL). The crude product was flash chromatographed on a silica column using dichioromethane as eluent. The dichloromethane was reduced in volume to about 5mL and then methanol (100mL) was added. The solution was, once more, reduced in volume to about 50mL and the yellow product filtered (sinter, porosity 3) and washed with further methanol (100mL). The product was dried in a vacuum oven at 80°C for 2 hours. Yield (0.30g, 46%).

### Device construction

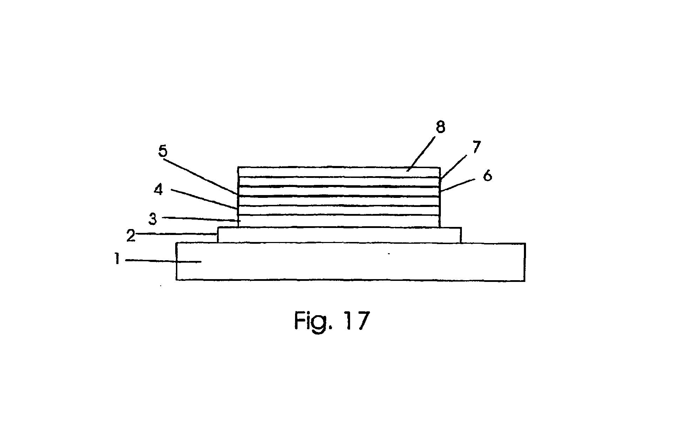

An electroluminescent device is shown in fig. 17, where the layers 1 to 8 were (1) ITO, (2) CuPc (3) α-NPB (4) the electroluminescent mixture (5) BCP (6) Alq₃ (7) LiF and (8) Al. To form the device a pre-etched ITO coated glass piece (10 x 10cm²) was used. The device was fabricated by sequentially forming the layers on the ITO, by vacuum evaporation using a Solciet Machine, ULVAC Ltd. Chigacki, Japan; the active area of each pixel was 3mm by 3mm; the structure was:-
ITO/CuPc(8nm)/α-NPB(40nm)/ CBP+Ir₂(diacac)₂ (dpp)₂ (12%)(20nm) /BCP(6nm)/ Alq3(20nm)/LiF(0.7mn)Al
where CBP is shown in fig. 4b with R being H, BCP is bathocupron and Ir₂(diacac)₂ (dpp)₂ is as synthesised in example 3.

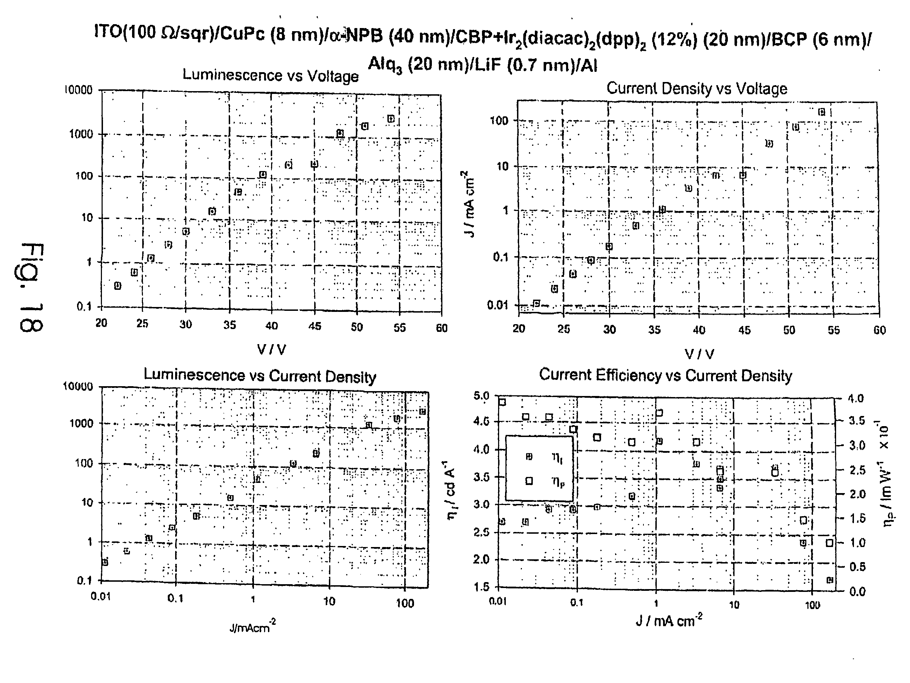

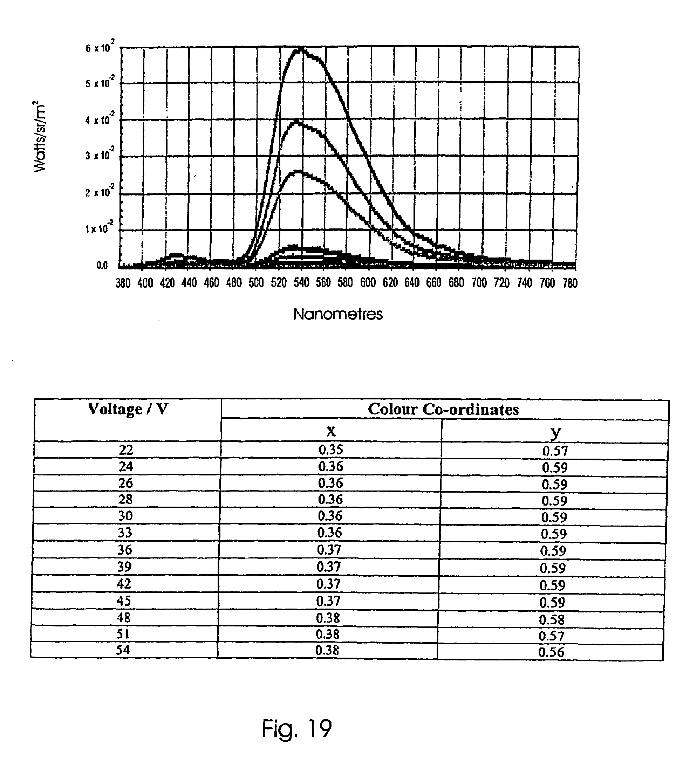

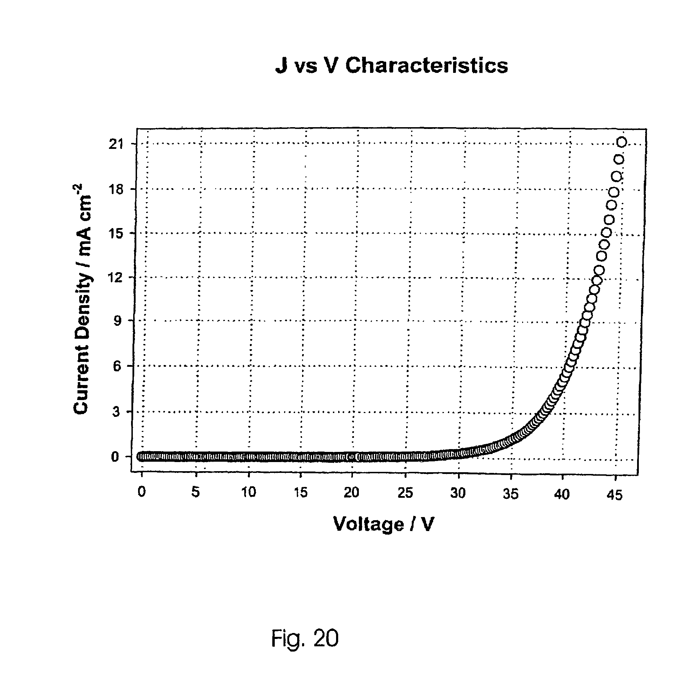

An electric current was passed through the device and the properties of the emitted light measured and the results are shown in figs. 18 to 20 of the drawings.

## Claims

1. An electroluminescent diiridium compound of formula 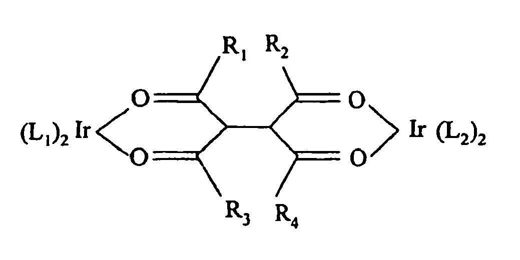 where R₁, R₂, R₃ and R₄ can be the same or different and are selected from hydrogen, and substituted and unsubstituted hydrocarbyl groups.

2. A compound according to claim 1 **characterised in that** R₁, R₂, R₃ and R₄ are selected from substituted and unsubstituted aliphatic groups, substituted and unsubstituted aromatic, heterocyclic and polycyclic ring structures, fluorocarbons such as trifluoryl methyl groups, halogens such as fluorine or thiophenyl groups; R₁, R₂ and R₃ can also form substituted and unsubstituted fused aromatic, heterocyclic and polycyclic ring structures and can be copolymerisable with a monomer and L₁ and L₂ are the same or different organic ligands.

3. A diiridium compound as claimed in to claim 2 **characterised in that** L₁ and L₂ are selected from phenyl pyridine and substituted phenylpryidines.

4. An electroluminescent device which comprises (i) a first electrode, (ii) a layer of the diiridium complex as claimed in to any one of claims 1 to 3 and (iii) a second electrode.

5. An electroluminescent device as claimed in to claim 6 **characterised in that** the diiridium complex is mixed with europium organo metallic or organic complex of formula
(Lα)₃Eu ←Lₚ
where Lα and Lp are organic ligands and Lp is a neutral ligand, the ligands Lα can be the same or different and there can be a plurality of ligands Lp which can be the same or different.

6. An electroluminescent device according to any one of claims 4 to 6 **characterised in that** there is a layer of a hole transmitting material between the first electrode and the electroluminescent layer.

7. An electroluminescent device according to claim 6 **characterised in that** the hole transmitting material is selected from aromatic amine complexes and conjugated polymers and films of a polymer selected from poly(vinylcarbazole), N,N'-diphenyl-N,N'-bis (3-methylphenyl) -1,1' -biphenyl -4,4'-diamine (TPD), polyaniline, substituted polyanilines, polythiophenes, substituted polythiophenes, polysilanes and substituted polysilanes, a polymer of a cyclic aromatic compound, poly (p-phenylenevinylene)-PPV and copolymers including PPV, poly(2,5 dialkoxyphenylene vinylene), poly (2-methoxy-5-(2-methoxypentyloxy-1,4-phenylene vinylene), poly(2-methoxypentyloxy)-1,4-phenylenevinylene), poly(2-methoxy-5-(2-dodecyloxy-1,4-phenylenevinylene) and other poly(2,5 dialkoxyphenylenevinylenes) with at least one of the alkoxy groups being a long chain solubilising alkoxy group, poly fluorenes and oligofluorenes, polyphenylenes and oligophenylenes, polyanthracenes and oligo anthracenes, ploythiophenes and oligothiophenes

8. An electroluminescent device according to any one of claims 4 to 7 **characterised in that** there is a layer of an electron transmitting material between the electroluminescent compound layer and the second electrode.

9. An electroluminescent device according to claim 8 **characterised in that** the electron transmitting material is selected from metal quinolates and cyano anthracenes, aluminium quinolate and lithium quinolate.

10. An electroluminescent device according any one of claims 4 to 9 **characterised in that** the second electrode is selected from aluminium, calcium, lithium and silver/magnesium alloys

## Patentansprüche

1. Elektrolumineszente Diiridiumverbindung der Formel: 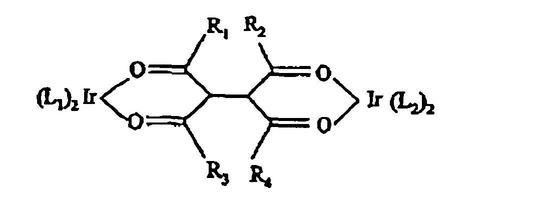 worin R₁, R₂, R₃ und R₄ gleich oder verschieden sein können und ausgewählt sind aus Wasserstoff und substituierten und unsubstituierten Kohlenwasserstoffgruppen.

2. Verbindung nach Anspruch 1, **dadurch gekennzeichnet, dass** R₁, R₂, R₃ und R₄ ausgewählt sind aus substituierten und unsubstituierten aliphatischen Gruppen, substituierten und unsubstituierten aromatischen, heterocyclischen und polycyclischen Ringstrukturen, Fluorkohlenwasserstoffen, wie Trifluormethylgruppen, Halogenen, wie Fluor, oder Thiophenylgruppen; R₁, R₂ und R₃ können ebenfalls substituierte und unsubstituierte kondensierte aromatische, heterocyclische und polycyclische Ringstrukturen bilden und können mit einem Monomer copolymerisierbar sein, und L₁ und L₂ sind gleiche oder verschiedene organische Liganden.

3. Diiridiumverbindung nach Anspruch 2, **dadurch gekennzeichnet, dass** L₁ und L₂ ausgewählt sind aus Phenylpyridin und substituierten Phenylpyridinen.

4. Elektrolumineszente Vorrichtung, die (i) eine erste Elektrode, (ii) eine Schicht des Diiridiumkomplexes nach irgendeinem der Ansprüche 1 bis 3, und (üi) eine zweite Elektrode aufweist.

5. Elektrolumineszente Vorrichtung nach Anspruch 6, **dadurch gekennzeichnet, dass** der Diiridiumkomplex mit einer organometallischen Europium-Verbindung oder einem organischen Komplex der Formel
(Lα)₃Eu←Lp
worin Lα und Lp organische Liganden darstellen und Lp einen Neutralligand darstellt, die Liganden Lα gleich oder verschieden sein können, und eine Vielzahl von Liganden Lp, die gleich oder verschieden sein können, vorhanden sein können, gemischt wird.

6. Elektrolumineszente Vorrichtung nach irgendeinem der Ansprüche 4 bis 6, **dadurch gekennzeichnet, dass** eine Schicht eines lochtransportiezenden Materials zwischen der ersten Elektrode und der elektroluxnineszenteu Schicht vorhanden ist.

7. Elektrolumineszente Vorrichtung nach Anspruch 6, **dadurch gekennzeichnet, dass** das lochtransportierends Material ausgewählt wird aus aromatischen Aminkomplexen und konjugierten Polymeren und Filmen eines Polymers, ausgewählt aus Poly(vinylcarbazol), N,N'-Diphenyl-N,N'-bis(3-methylphenyl)-1,1'-biphenyl-4,4'-diamin (TPD), Polyanilin, substituierten Polyanilinen, Polythiophenen, substituierten Polythiophenen, Polysilanen und substituierten Polysilanen, einem Polymer einer cyclischen aromatischen Verbindung, Poly(p-phenylenvinylen)-PPV und PPV enthaltenden Copolymeren, Poly(2,5-dialkoxyphenylenvinylen), Poly(2-methoxy 5-(2-methoxypentyloxy-1,4-phenylenvinylen), Poly(2-methoxypentyloxy)-1,4-phenylenvinylen), Poly(2-methoxy-5-(2-dodecyloxy-1,4-phenylenvinylen) und anderen Poly(2,5-dialkoxyphenylenvinylenen), wobei mindestens eine der Alkoxygruppen eine langkettige lösungsvermittelnde Alkoxygruppe darstellt, Polyfluorene und Oligofluorene, Polyphenylene und Oligophenylene, Polyanthracene und Oligoanthracene, Polythiophene und Oligothiophene.

8. Elektrolumineszente Vorrichtung nach irgendeinem der Ansprüche 4 bis 7, **dadurch gekennzeichnet, dass** eine Schicht elektronentransportierenden Materials zwischen der elektrolumineszenten Verbindungsschicht und der zweiten Elektrode vorhanden ist.

9. Elektrolumineszente Vorrichtung nach Anspruch 8, **dadurch gekennzeichnet, dass** das elektronentransportierende Material ausgewählt ist aus Metallchinolaten und Cyanoanthracenen, Aluminiumchinolat und Lithiumchinolat.

10. Elektrolumineszente Vorrichtung nach irgendeinem der Ansprüche 4 bis 9, **dadurch gekennzeichnet, dass** die zweite Elektrode ausgewählt ist aus Aluminium-, Calcium-, Lithium- und Silber-/Magnesium-Legierungen.

## Revendications

1. Composé de diiridium électroluminescent de formule 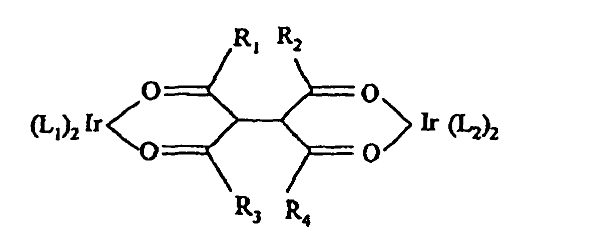 dans laquelle R₁, R₂, R₃ et R₄ peuvent être identiques ou différents et sont choisis parmi un atome d'hydrogène et des groupes hydrocarbyle substitués et non substitués.

2. Composé selon la revendication 1, **caractérisé en ce que** R₁, R₂, R₃ et R₄ sont choisis parmi les groupes aliphatiques substitués et non substitués, les structures cycliques aromatiques, hétérocycliques et polycycliques substituées et non substituées, les fluorocarbures tels que les groupes trifluorylméthyle, les atomes d'halogène tels que le fluor, ou des groupes thiophényle ; R₁, R₂ et R₃ peuvent également former des structures cycliques aromatiques, hétérocycliques et polycycliques condensées substituées et non substituées et peuvent être copolymérisables avec un monomère, et L₁ et L₂ représentent des ligands organiques identiques ou différents.

3. Composé de diiridium selon la revendication 2, **caractérisé en ce que** L₁ et L₂ sont choisis parmi la phénylpyridine et les phénylpyridines substituées.

4. Dispositif électroluminescent qui comprend (i) une première électrode, (ii) une couche de complexe de diiridium selon l'une quelconque des revendications 1 à 3 et (iii) une deuxième électrode.

5. Dispositif électroluminescent selon la revendication 6, **caractérisé en ce que** le complexe de diiridium est mélangé avec un complexe métallique ou organométallique d'europium de formule
(Lα)₃Eu ← Lp
dans laquelle Lα et Lp représentent des ligands organiques et Lp représente un ligand neutre, les ligands Lα peuvent être identiques ou différents et il peut y avoir une pluralité de ligands Lp qui peuvent être identiques ou différents.

6. Dispositif électroluminescent selon l'une quelconque des revendications 4 à 6, **caractérisé en ce qu'**une couche de matière d'émission de trous se trouve entre la première électrode et la couche électroluminescente.

7. Dispositif électroluminescent selon la revendication 6, **caractérisé en ce que** la matière d'émission de trous est choisie parmi les complexes d'amines aromatiques et les polymères conjugués et les films d'un polymère choisi parmi le poly(vinylcarbazole), la N,N'-diphényl-N,N'-bis(3-méthylphényl)-1,1'-biphényl-4,4'-diamine (TPD), la polyaniline, les polyanilines substituées, les polythiophènes, les polythiophènes substitués, les polysilanes et les polysilanes substitués, un polymère d'un composé cyclique aromatique, le poly(p-phénylènevinylène) (PPV) et les copolymères comprenant le PPV, le poly(2,5-dialcoxyphénylènevinylène), le poly(2-méthoxy-5-(2-méthoxypentyloxy-1,4-phénylènevinylène), le poly(2-méthoxypentyloxy)-1,4-phénylènevinylène), le poly(2-méthoxy-5-(2-dodécyloxy-1,4-phénylènevinylène) et d'autres poly(2,5-dialcoxyphénylènevinylène), au moins un des groupes alcoxy étant un groupe alcoxy solubilisant à longue chaîne, les polyfluorènes et les oligofluorènes, les polyphénylènes et les oligophénylènes, les polyanthracènes et les oligoanthracènes, les polythiophènes et les oligothiophènes.

8. Dispositif électroluminescent selon l'une quelconque des revendications 4 à 7, **caractérisé en ce qu'**une couche de matière d'émission d'électrons se trouve entre la couche de composé électroluminescent et la deuxième électrode.

9. Dispositif électroluminescent selon la revendication 8, **caractérisé en ce que** la matière d'émission d'électrons est choisie parmi les quinoléates métalliques et les cyanoanthracènes, le quinoléate d'aluminium et le quinoléate de lithium.

10. Dispositif électroluminescent selon l'une quelconque des revendications 4 à 9, **caractérisé en ce que** la deuxième électrode est choisie parmi l'aluminium, le calcium, le lithium et les alliages argent/magnésium.
